(19) Europäisches Patentamt
European Patent Office
Office européen des brevets

(11) **EP 2 665 348 A1**

(12) **EUROPÄISCHE PATENTANMELDUNG**

(43) Veröffentlichungstag:
20.11.2013 Patentblatt 2013/47

(51) Int Cl.:
*H05K 7/14* (2006.01)    *G01K 7/42* (2006.01)

(21) Anmeldenummer: 12167922.9

(22) Anmeldetag: 14.05.2012

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(71) Anmelder: **Siemens Aktiengesellschaft**
**80333 München (DE)**

(72) Erfinder:
• **Kort, Valentin**
  **76829 Landau (DE)**
• **Cyron, Michael**
  **76187 Karlsruhe (DE)**
• **Marenski, Dirk**
  **76131 Karlsruhe (DE)**

(54) **Baugruppe für ein modulares Automatisierungsgerät**

(57)    Es wird eine Baugruppe für ein modulares Automatisierungsgerät vorgeschlagen, mit einer in einer Gehäusekapsel (3) angeordneten SMD-Leiterplatte (6), welche auf einer Seite (S1) der Leiterplatte (6) einen SMD-Sensor (7) zur Erfassung der Temperatur ($T_7$) der Zuluft in der Gehäusekapsel (3) aufweist, wobei die Zuluft durch Lufteintrittsöffnungen der Gehäusekapsel (3) über die SMD-Leiterplatte (6) und schließlich durch Luftaustrittsöffnungen (4) der Gehäusekapsel (3) strömt und wobei der SMD-Sensor (7) die erfasste Temperatur ($T_7$) einer Überwachungseinheit zur Auswertung übermittelt. Mittels geeigneter Maßnahmen wird eine genauere Ermittlung der Zulufttemperatur ermöglicht.

FIG 1

EP 2 665 348 A1

**Beschreibung**

Die Erfindung betrifft eine Baugruppe für ein modulares Automatisierungsgerät, mit einer in einer Gehäusekapsel angeordneten SMD-Leiterplatte, welche auf einer Seite der Leiterplatte einen SMD-Sensor zur Erfassung der Temperatur der Zuluft in der Gehäusekapsel aufweist, wobei die Zuluft durch Lufteintrittsöffnungen der Gehäusekapsel über die SMD-Leiterplatte und schließlich durch Luftaustrittsöffnungen der Gehäusekapsel strömt und wobei der SMD-Sensor die erfasste Temperatur einer Überwachungseinheit zur Auswertung übermittelt. Ferner betrifft die Erfindung eine Leiterplatte für eine solche Baugruppe.

Derartige Baugruppen sind aus dem Siemens-Katalog ST 70, Kapitel 5, Ausgabe 2011 bekannt. Die auf einen Träger montierbaren Baugruppen sind Bestandteil eines modularen Automatisierungsgerätes und weisen jeweils innerhalb einer Gehäusekapsel eine mit elektrischen und elektronischen Bauteilen versehene SMD-Leiterplatte auf. Die Entwärmung dieser Bauteile erfolgt im Wesentlichen durch Konvektion in der Art und Weise, dass Luft durch eine Öffnung auf der Unterseite der Gehäusekapsel, über die Bauteile und schließlich durch eine Öffnung auf der Oberseite der Gehäusekapsel strömt, wobei die durch das Gehäuse strömende Luft den Bauteilen Wärme entzieht. In vielen Fällen sind die Baugruppen für einen Einsatz in einer rauen Prozessumgebung bis zu einer vorgegebenen Umgebungstemperatur ausgelegt und es ist daher erforderlich, während des Betriebs des Automatisierungsgerätes die Zulufttemperatur in der jeweiligen Baugruppe zu kennen, um sicherzustellen, dass die Baugruppe in der für sie spezifizierten Umgebungstemperatur betrieben werden kann.

Um die Temperatur der Zuluft zu erfassen, weist die SMD-Leiterplatte einen SMD-Sensor auf, wobei für den Fall, dass die Temperatur einen Schwellwert erreicht oder übersteigt, eine Temperaturüberwachungseinheit einem Anwender einen Fehler anzeigt. Aufgrund der SMD-Bauweise wird zwar der Platzbedarf der Bauelemente auf der Leiterplatte verringert, nachteilig ist allerdings, dass die Verlustwärme der Baugruppe den SMD-Sensor im Hinblick auf eine genaue Erfassung der Zulufttemperatur störend beeinflusst. Beispielsweise verfälschen auf der Leiterplatte angeordnete Wärmequellen in Form von Transformatoren oder Feldeffekttransistoren das Messergebnis des SMD-Sensors, d. h. die durch den Sensor erfasste Zulufttemperatur entspricht nicht der tatsächlichen Zulufttemperatur.

Der Erfindung liegt daher die Aufgabe zugrunde, eine Baugruppe der eingangs genannten Art zu schaffen, welche eine genauere Auswertung der Zulufttemperatur ermöglicht. Darüber hinaus ist eine Leiterplatte anzugeben, welche für einen Einsatz in einer derartigen Baugruppe geeignet ist.

Diese Aufgabe wird im Hinblick auf die Baugruppe durch die im kennzeichnenden Teil des Anspruchs 1, bezüglich der Leiterplatte durch die im kennzeichnenden Teil des Anspruchs 3 angegebenen Maßnahmen gelöst.

Vorteilhaft ist, dass die Zulufttemperatur genauer bestimmt werden kann, indem die Leiterplattentemperatur für eine Auswertung berücksichtigt wird. Verfälschungen des Messergebnisses im Hinblick auf die Zulufttemperatur aufgrund von auf der Leiterplatte angeordneten Wärmequellen werden weitgehend vermieden, was bedeutet, dass eine Erhöhung der erfassten Zulufttemperatur, die durch die Wärmezufuhr der Wärmequellen der Leiterplatte entsteht, bei der Ermittlung der tatsächlichen Zulufttemperatur weitgehend eliminiert wird.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:

Figur 1 auf einer SMD-Leiterplatte angeordnete Sensoren und
Figur 2 eine Baugruppe eines Automatisierungsgerätes.

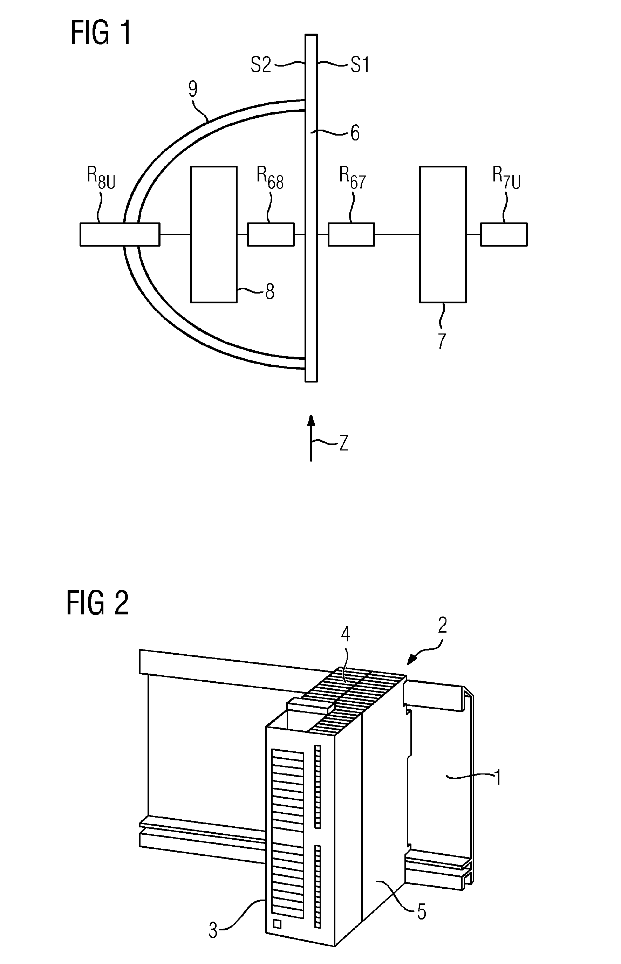

Es wird zunächst auf Figur 2 verwiesen, in welcher eine an sich bekannte, auf einem Träger 1 angeordnete Baugruppe 2 eines Automatisierungsgerätes dargestellt ist. Die Entwärmung erfolgt im Wesentlichen durch Konvektion in der Art und Weise, dass Zuluft durch Öffnungen (Lufteintrittsöffnungen) auf der Unterseite einer Gehäusekapsel 3 über die elektrischen und elektronischen Bauteile der Baugruppe und schließlich durch eine Öffnung 4 (Luftaustrittsöffnungen) auf der Oberseite der Gehäusekapsel 2 strömt, wobei die durch die Gehäusekapsel 3 strömende Luft den auf einer SMD-Leiterplatte angeordneten bzw. montierten Bauteilen Wärme entzieht. Die SMD-Leiterplatte ist in der Gehäusekapsel 3 parallel zur Seitenwand 5 der Gehäusekapsel 3 positioniert bzw. angeordnet und weist einen SMD-Sensor zur Erfassung der Zulufttemperatur auf.

Um zu vermeiden, dass auf der Leiterplatte angeordnete Wärmequellen das Messergebnis im Hinblick auf die Zulufttemperatur verfälschen, ist ein weiterer SMD-Sensor zur Erfassung der Leiterplattentemperatur vorgesehen. Diese Leiterplattentemperatur wird bei der Auswertung der erfassten Zulufttemperatur berücksichtigt und weitgehend eliminiert.

Zur näheren Erläuterung wird dazu im Folgenden auf Figur 1 verwiesen, in welcher in einer stark vereinfachten Form eine SMD-Leiterplatte 6 mit SMD-Sensoren 7, 8 dargestellt ist, wobei zum besseren Verständnis der Erfindung thermische Widerstände eingezeichnet sind. Diese thermischen Widerstände werden nachfolgend der Einfachheit halber als Widerstände $R_{67}$, $R_{68}$, $R_{7U}$, $R_{8U}$ bezeichnet. Der Widerstand $R_{67}$ repräsentiert den thermischen Übergangswiderstand von der SMD-Leiterplatte 6 zum Sensor 7 und der Widerstand $R_{68}$ den thermischen Übergangswiderstand von der SMD-Leiterplatte 6 zu einem weiteren Sensor 8, wobei der Sensor 7 zur Erfassung der Zulufttemperatur und der Sensor 8 zur Erfassung der Leiterplattentemperatur vorgesehen ist. Ferner repräsentiert der Widerstand $R_{7U}$ den thermischen Übergangswiderstand vom Sensor 7 zu einer Zuluft Z bzw. Umgebungsluft und der Widerstand $R_{8U}$ den thermischen Übergangswiderstand vom Sensor 8 zu Umgebungsluft, wobei der Widerstandswert dieses Widerstands $R_{8U}$ aufgrund der thermischen Entkopplung des Sensors 8 von der Umgebung mittels einer Abdeckung 9 sehr viel größer ist als der Widerstandswert des Widerstands $R_{7U}$.

Die Leistungsauf- bzw. -abnahmen der Leiterplatte einerseits und der Sensoren 7, 8 andererseits sind im Wesentlichen identisch - ansonsten würden sich die Sensoren 7, 8 und die Leiterplatte 6 aufwärmen bzw. abkühlen - so dass gilt:

$$\frac{T_6 - T_7}{R_{67}} = \frac{T_7 - T_z}{R_{7U}} \qquad (1)$$

sowie

$$\frac{T_6 - T_8}{R_{68}} = \frac{T_8 - T_z}{R_{8U}} \qquad (2)$$

wobei

- $T_6$ die Temperatur der Leiterplatte 6,
- $T_7$ die erfasste Temperatur des Sensors 7,
- $T_8$ die erfasste Temperatur des Sensors 8,
- $T_z$ die Zuluft- bzw. Umgebungstemperatur und
- $R_{67}$, $R_{68}$, $R_{7U}$, $R_{8U}$ die oben genannten thermischen Widerstände sind, wobei $R_{8U} \gg R_{7U}$ und $R_{67} = R_{68}$.

Aus Gleichung (2) ergibt sich

$$T_6 = \frac{T_8 - T_Z}{R_{8U}} \times R_{68} + T_8 \qquad (3)$$

und aus dieser Gleichung (3) - da $R_{8U} \gg R_{68}$ ist,

$$T_6 = T_8 \qquad (4)$$

Aus den Gleichungen (1) und (4) berechnet sich somit die Zulufttemperatur $T_z$ zu:

$$T_Z = T_7 - \frac{T_8 - T_7}{R_{67}} \times R_{7U} \qquad (5)$$

Mit anderen Worten: Die Temperatur der SMD-Leiterplatte 6 ist aufgrund der Messung mit dem weiteren Sensor 8 bekannt, da dieser Sensor 8 im Idealfall dieselbe Temperatur wie die Leiterplatte 6 aufweist (s. Gleichungen (3) u. (4)). Durch die örtliche Nähe des weiteren Sensors 8 zum Sensor 7 ist die Temperatur der Leiterplatte 6 am Einbauplatz des Sensors 7 bekannt. Die Widerstandswerte der Widerstände $R_{67}$ und $R_{7U}$ sind ebenfalls bekannt - diese werden werksseitig für eine Baugruppenreihe ermittelt - wodurch die von der Leiterplatte 6 bewirkte Temperaturerhöhung von der mittels des Sensors 7 erfassten Zulufttemperatur "herausgerechnet" werden kann. Die Zulufttemperatur der Umgebungsluft kann somit wesentlich genauer bestimmt werden.

Die Erfindung lässt sich damit wie folgt zusammenfassen: Eine Baugruppe für ein modulares Automatisierungsgerät, mit einer in einer Gehäusekapsel 3 angeordneten SMD-Leiterplatte 6, welche auf einer Seite S1 der Leiterplatte 6 einen SMD-Sensor 7 zur Erfassung der Temperatur $T_7$ der Zuluft in der Gehäusekapsel 3 aufweist, wobei die Zuluft durch Lufteintrittsöffnungen der Gehäusekapsel 3 über die SMD-Leiterplatte 6 und schließlich durch Luftaustrittsöffnungen 4 der Gehäusekapsel 3 strömt und wobei der SMD-Sensor 7 die erfasste Temperatur $T_7$ einer Überwachungseinheit zur Auswertung übermittelt, zeichnet sich dadurch aus, dass ein weiterer SMD-Sensor 8 zur Erfassung der Leiterplattentemperatur $T_6$ benachbart zum Sensor 7 oder dem SMD-Sensor 7 gegenüberliegend auf einer der einen Seite S1 gegenüberliegenden anderen Seite S2 der Leiterplatte 6 angeordnet ist, wobei der weitere SMD-Sensor 8 von der Zuluft thermisch entkoppelt ist, und wobei der weitere SMD-Sensor 8 die erfasste Temperatur $T_6$ ebenfalls der Überwachungseinheit zur Auswertung übermittelt.

Mittels derartiger Maßnahmen wird eine genauere Ermittlung der Zulufttemperatur $T_z$ ermöglicht.

**Patentansprüche**

1. Baugruppe für ein modulares Automatisierungsgerät, mit einer in einer Gehäusekapsel (3) angeordneten SMD-Leiterplatte (6), welche auf einer Seite (S1) der Leiterplatte (6) einen SMD-Sensor (7) zur Erfassung der Temperatur ($T_7$) der Zuluft in der Gehäusekapsel (3) aufweist, wobei die Zuluft durch Lufteintrittsöffnungen der Gehäusekapsel (3) über die SMD-Leiterplatte (6) und schließlich durch Luftaustrittsöffnungen (4) der Gehäusekapsel (3) strömt und wobei der SMD-Sensor (7) die erfasste Temperatur ($T_7$) einer Überwachungseinheit zur Auswertung übermittelt, **dadurch gekennzeichnet, dass** ein weiterer SMD-Sensor (8) zur Erfassung der Leiterplattentemperatur ($T_6$) benachbart zum Sensor (7) oder dem SMD-Sensor (7) gegenüberliegend auf einer der einen Seite (S1) gegenüberliegenden anderen Seite (S2) der Leiterplatte (6) angeordnet ist, wobei der weitere SMD-Sensor (8) von der Zuluft thermisch entkoppelt ist, und wobei der weitere SMD-Sensor (8) die erfasste Temperatur ($T_6$) ebenfalls der Überwachungseinheit zur Auswertung übermittelt.

2. Baugruppe nach Anspruch 1, **dadurch gekennzeichnet, dass** die Überwachungseinheit die Zulufttemperatur ($T_z$) aus der erfassten Zulufttemperatur ($T_7$) und der erfassten Leiterplattentemperatur ($T_8$) berechnet.

3. SMD-Leiterplatte für eine Baugruppe nach Anspruch 1 oder 2, wobei die SMD-Leiterplatte (6) einen SMD-Sensor (7) zur Erfassung der Temperatur der Zuluft in einer Gehäusekapsel (3) der Baugruppe (2) aufweist, **dadurch gekennzeichnet, dass** ein weiterer SMD-Sensor (8) zur Erfassung der Leiterplattentemperatur benachbart zum SMD-Sensor (7) oder dem SMD-Sensor (7) gegenüberliegend auf einer der einen Seite (S1) gegenüberliegenden anderen Seite (S2) der Leiterplatte (6) angeordnet ist, wobei der weitere SMD-Sensor (8) von der Zuluft thermisch entkoppelt ist.

## FIG 1

## FIG 2

Europäisches
Patentamt

European
Patent Office

Office européen
des brevets

# EUROPÄISCHER RECHERCHENBERICHT

**Nummer der Anmeldung**

EP 12 16 7922

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2008 056846 A1 (INFINEON TECHNOLOGIES AG [DE]) 4. Juni 2009 (2009-06-04) | 3 | INV. H05K7/14 G01K7/42 |
| A | * Absätze [0030] - [0046]; Abbildungen 1-11 * | 1,2 | |
| | ----- | | |
| A | DE 101 47 946 A1 (SIEMENS AG [DE]) 30. April 2003 (2003-04-30) * Absätze [0001], [0019] - [0024]; Abbildung 1 * | 1-3 | |
| | ----- | | |
| A | US 2009/312999 A1 (KASZTENNY BOGDAN Z [CA] ET AL) 17. Dezember 2009 (2009-12-17) * das ganze Dokument * | 1-3 | |
| | ----- | | |
| A | US 2002/080852 A1 (MIROV RUSSELL N [US]) 27. Juni 2002 (2002-06-27) * das ganze Dokument * | 1-3 | |
| | ----- | | |

RECHERCHIERTE SACHGEBIETE (IPC)

H05K
G01K
G05B

Der vorliegende Recherchenbericht wurde für alle Patentansprüche erstellt

| Recherchenort | Abschlußdatum der Recherche | Prüfer |
|---|---|---|
| Den Haag | 14. Februar 2013 | Kaluza, Andreas |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
   Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**          EP 12 16 7922

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-02-2013

| Im Recherchenbericht angeführtes Patentdokument | Datum der Veröffentlichung | Mitglied(er) der Patentfamilie | | Datum der Veröffentlichung |
|---|---|---|---|---|
| DE 102008056846 A1 | 04-06-2009 | DE 102008056846 A1 | | 04-06-2009 |
| | | US 2009129432 A1 | | 21-05-2009 |
| DE 10147946 A1 | 30-04-2003 | KEINE | | |
| US 2009312999 A1 | 17-12-2009 | AU 2009260382 A1 | | 23-12-2009 |
| | | CA 2726819 A1 | | 23-12-2009 |
| | | CN 102067049 A | | 18-05-2011 |
| | | EP 2300885 A1 | | 30-03-2011 |
| | | JP 2011524591 A | | 01-09-2011 |
| | | KR 20110020830 A | | 03-03-2011 |
| | | US 2009312999 A1 | | 17-12-2009 |
| | | WO 2009155149 A1 | | 23-12-2009 |
| US 2002080852 A1 | 27-06-2002 | US 2002080852 A1 | | 27-06-2002 |
| | | US 2004027115 A1 | | 12-02-2004 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- Siemens-Katalog ST 70. 2011